# EUROPEAN PATENT APPLICATION

(11) **EP 0 706 203 A1**
(43) Date of publication of application: **10.04.1996**
(21) Application number: 95250220.1
(22) Date of filing: 12.09.1995
(51) Int. Cl.: H01L 21/20, H01L 21/762

(54) **Method of manufacturing SOI substrate**

(30) Priority: 14.09.1994 JP 219709/94
(71) Applicant: NIPPON TELEGRAPH AND TELEPHONE CORPORATION, Shinjuku-ku Tokio 163-19 (JP)
(72) Inventor: Unno, Hideyuki, Ebina-shi, Kanagawa-ken (JP); Imai, Kazuo, Atsugi-shi, Kanagawa-ken (JP)
(74) Representative: Patentanwälte Wenzel & Kalkoff

(57) **Abstract**

In a method of manufacturing an SOI substrate, a semiconductor layer is formed on one surface of a first semiconductor substrate containing an impurity of a certain conductivity type at a first impurity concentration. This semiconductor layer contains the impurity of a certain conductivity type at a second impurity concentration higher than the first impurity concentration. The surface of the semiconductor layer of the first semiconductor substrate is bonded to a second semiconductor substrate covered with an insulating film. The semiconductor layer is exposed by removing the first semiconductor substrate from the surface on which the semiconductor layer is not formed. The impurity concentration of the semiconductor layer is decreased by heating the second semiconductor substrate, bonded to the semiconductor layer, in a reducing atmosphere.

## Description

### Background of the Invention

The present invention relates to a method of manufacturing an SOI substrate.

The silicon LSI technologies have advanced very rapidly to continuously decrease the device dimensions, and there is an unceasing increase in the LSI scale such as represented by a DRAM. Accordingly, the requirements for a high-speed, low-consumption-power LSI are becoming more and more strict.

Under the circumstances, the problems that the conventional bulk silicon must solve to realize these requirements are being increased. One problem is device isolation. Although the device size is reduced, it is difficult to decrease the device isolation width or the film thickness in order to prevent latch-up or mutual interference between the devices. Also, the junction capacitance becomes an important factor for determining the device performance, and this capacitance prevents the operating speed from being increased.

An SOI (Silicon On Insulator) substrate solves these problems. In an SOI substrate, since devices are completely surrounded by an insulating film, no latch-up takes place. Additionally, the film thickness of a device isolation region can be decreased because the film thickness need only be equal to the silicon film thickness on an SOI substrate. This makes micro-processing possible even with the conventional device isolation technologies. Also, the side and bottom surfaces of a device are surrounded by an insulating film, so the junction capacitance can be decreased to result in a high speed. For the reasons described above, an SOI substrate is being considered promising as a large-scale, high-performance LSI substrate in the future.

The development of such an SOI substrate is being competitively done by wafer manufacturers and semiconductor device manufacturers in Japan and foreign countries, and various proposals have been made. Among other proposals, a SIMOX (Separation by IMplanted OXygen) method using oxygen ion implantation is a well-known technique and is being developed to be put into practical use in research institutions all over the world. Unfortunately, this method has the problem that the crystallinity of a silicon layer on an insulating film is impaired since high dose oxygen ion implantation is performed. Recently, a method is reported in which the crystallinity of a silicon layer is improved by improving the annealing conditions after the ion implantation. However, no silicon layers with crystallinity meeting the requirements have been attained yet.

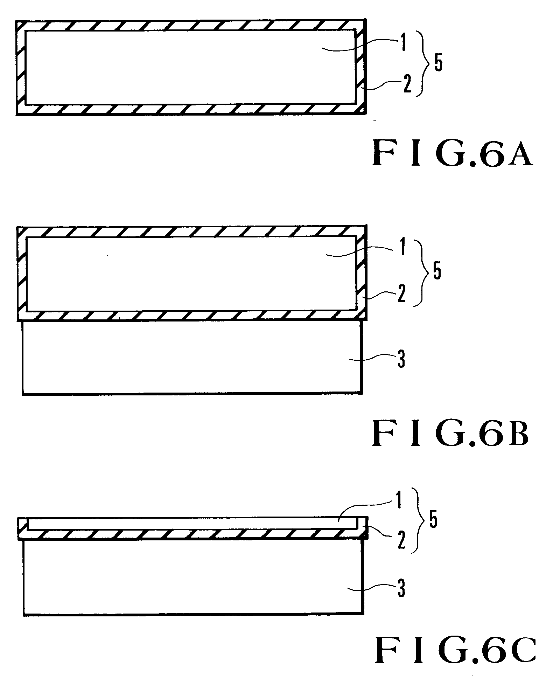

In addition to the SIMOX method, various methods have been proposed as the method of manufacturing an SOI substrate. Among other methods, the wafer bonding technique is attracting attention in recent years. Figs. 6A to 6C illustrate an SOI substrate manufacturing method using the bonding technique.

First, as shown in Fig. 6A, the surfaces of a silicon layer (active layer) 1 are thermally oxidized to form a silicon oxide film 2, thereby preparing an active layer side wafer 5. Subsequently, as in Fig. 6B, this active layer side wafer 5 is bonded to a silicon wafer serving as a handle or base wafer 3. Thereafter, as in Fig. 6C, the upper surface of the active layer side wafer 5 serving as an active layer is ground and polished to expose the principal surface of the silicon layer (active layer) 1 having a desired thickness. Unfortunately, in this bonding method, the thickness of the silicon layer (active layer) 1 formable by the grinding and polishing is at most about 2 µm, so it is difficult for the state-of-the-art polishing technique to further decrease the film thickness.

As another technique by which the thickness of an SOI layer can be decreased to 1 µm or less, a PACE (Plasma Assisted Chemical Etching: chemical etching using a plasma) is reported recently. In this technique, an SOI substrate having an SOI layer whose thickness is decreased to about 2 µm by the grinding and polishing described above is used, and the thickness of this SOI layer is further decreased to about 0.1 µm by using plasma etching. Although this technique is considered to be further improved henceforth, the current situation is that a number of problems in respect of productivity and cost to put the method into practical use remain unsolved.

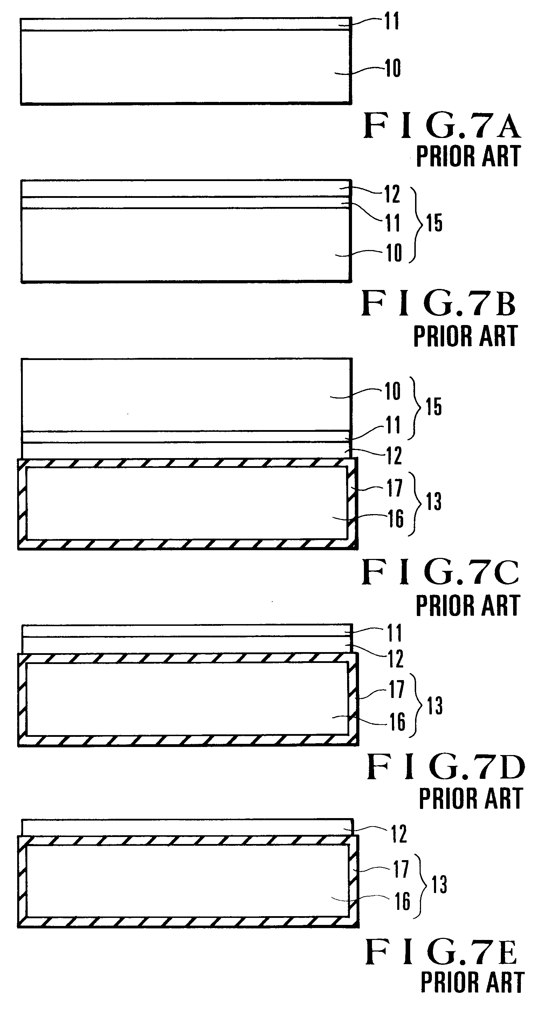

In addition to the above techniques, etch-stop methods are available as the method of forming a thin SOI layer with a thickness of 1 µm or smaller, and a double etch-stop method illustrated in Figs. 7A to 7E is one known example. In this technique, a p-type heavily doped silicon layer 11 is formed by ion implantation or diffusion on a lightly doped silicon wafer 10 on which an active layer is to be formed (Fig. 7A). In addition, as illustrated in Fig. 7B, on this p-type heavily doped silicon 11, a lightly doped silicon layer (active layer) 12 serving as an active layer is formed by epitaxial growth, thereby forming an active layer side wafer 15. Thereafter, the active layer side wafer 15 and a handle wafer 13 are bonded as in Fig. 7C. This handle wafer 13 has a structure in which the surfaces of a silicon wafer 16 are covered with a silicon oxide film 17.

Selective etching of silicon is then performed using a KOH (potassium hydroxide) solution or an EPW (Ethylenediamine Pyrocatechol Water) solution. The etching solution used in this selective etching has the properties by which the etch selectivity is brought about by the concentration of an impurity contained in silicon; that is, the higher the impurity concentration, the lower the etching rate, and silicon is hardly etched if the impurity concentration in silicon is 6 x 10¹⁹ /cm³ or higher. When this selective etching is performed, the handle wafer 13 is not etched because its surfaces are covered with the silicon oxide film (thermal oxide film) 17, so only silicon on the active layer side is etched. That is, the etching of the silicon wafer 10 proceeds and stops when the heavily doped (p-type) silicon layer 11 is exposed. This state is illustrated in Fig. 7D. Subsequently, the p-type heavily doped silicon layer 11 is etched using an etching solution, such as a 1-3-8 etching solution [a 1 : 3 : 8 mixed acid of HF (hydrofluoric acid) : HNO₃ (nitric acid) : CH₃COOH (acetic acid)], having the properties opposite to those of the KOH or EPW solution used in the previous etching, i.e., the properties by which the higher the impurity concentration, the higher the etching rate. As shown in Fig. 7E, by this etching, it is possible to form a lightly doped silicon layer (active layer) 12 on the handle wafer 13, i.e., on the insulating film (silicon oxide film 17).

It is unfortunate that this double etch method needs a high-level technique called a thin-film epitaxial technique. Also, since the selective etching is performed twice with the opposite properties, the thickness uniformity of the thin silicon film formed is degraded.

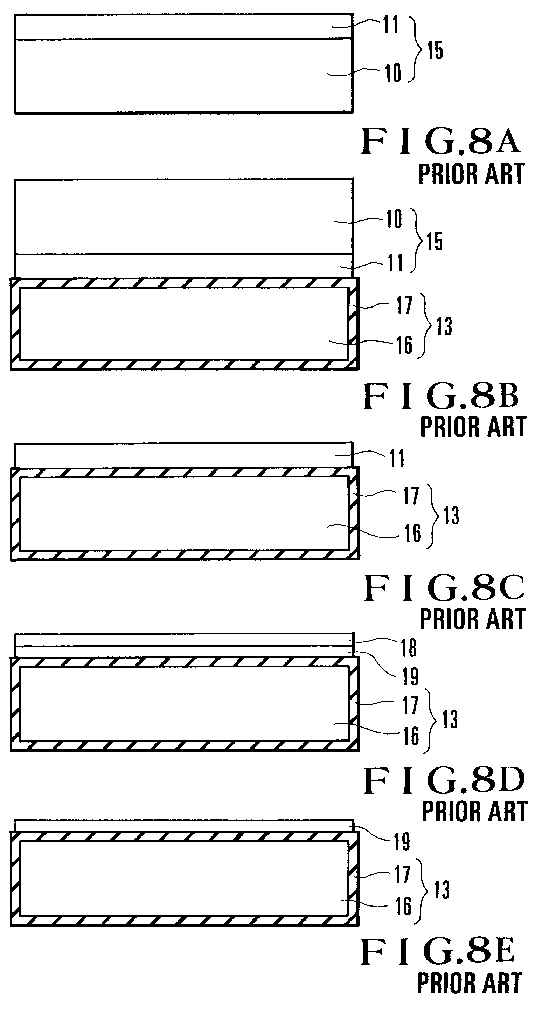

Figs. 8A to 8E show still another method of manufacturing a thin-film SOI substrate by using a single etch-stop method. In this method, as illustrated in Fig. 8A, a p-type heavily doped silicon layer 11 is formed by ion implantation or diffusion on a lightly doped silicon wafer 10 on which an active layer is to be formed, thereby forming an active layer side wafer 15. Subsequently, as in Fig. 8B, the p-type heavily doped silicon layer 11 of this active layer side wafer 15 is bonded to a handle wafer 13 on the surfaces of which a silicon oxide film 17 is formed by thermally oxidizing a silicon wafer 16. Thereafter, as in Fig. 8C, the lightly doped silicon wafer 10 on the active layer side is selectively etched using a KOH solution or an EPW solution.

A portion of the heavily doped silicon layer 11 is then oxidized while controlling the oxidation conditions such that the heavily doped silicon layer 11 is not entirely turned into an oxide film. The result is that boron (B) in the heavily doped p-type silicon is drawn out to the formed silicon oxide film, 18, due to the difference in the segregation coefficient between the silicon and the oxide film. The impurity concentration in the remaining heavily doped p-type silicon layer 11 is decreased compared to that before the oxidation, resulting in a lightly or moderately doped silicon layer 19 being formed (Fig. 8D). As shown in Fig. 8E, removing the silicon oxide film 18 leaves behind a thin-film SOI substrate in which the lightly or moderately doped silicon layer 19 is formed on the silicon oxide film 17 of the handle wafer 13 (Fig. 8E).

Table 1 below shows the relationship between the oxidation condition, the film thickness of the residual silicon film 19, and the boron concentration in the silicon film (K. Imai: J.J.A.P. Vol. 30, No. 6 (1991), p. 1154). Each boron concentration in Table 1 was obtained as follows. That is, the film thickness of a heavily doped p-type silicon layer was decreased to 0.5 µm by selective etching, and the resultant heavily doped p-type silicon layer was oxidized in an oxidizing atmosphere. The oxide film formed was removed by etching using, e.g., HF, and the boron concentration in the silicon film remaining on an insulating film was analyzed by SIMS (Secondary Ion Mass Spectroscopy).

**Table 1**

| Oxidation time (min) | Oxide film thickness (nm) | Silicon film thickness (nm) | Boron concentration (cm⁻³) |
|---|---|---|---|
| 0 | 0 | 480 | 7 x 10¹⁸ |
| 200 | 300 | 350 | 1 x 10¹⁹ |
| 600 | 650 | 200 | 2 x 10¹⁸ |
| 1000 | 880 | 90 | 4 x 10¹⁷ |

When the thickness of the silicon film 19 is decreased to 0.09 µm, the impurity concentration lowers to approximately 4 x 10¹⁷ /cm³ by which device fabrication is possible. However, when the thickness of the silicon film 19 is 0.2 µm, the boron concentration is as high as 2 x 10¹⁸ /cm³ by which fabrication of a device in the silicon film 19 is difficult. In this method using combination of etch-stop and oxidation, selective etching needs to be performed only once. Consequently, the uniformity of the silicon film thickness is improved in comparison with that in the double etch-stop method, and the film thickness controllability is also improved since the final silicon film thickness can be controlled by the oxidation reaction after the selective etching. This allows the method to be applied to devices using a silicon film whose thickness is 0.1 µm or smaller. However, the method is unapplicable to devices which require a silicon layer having a film thickness of 0.1 µm or larger. That is, the method has the disadvantage of narrowing the application range of an SOI substrate.

As described above, the SOI substrate manufacturing method using the conventional bonding technique has the problem that the thickness of an SOI layer cannot be decreased to less than 1 µm by the state-of-the-art polishing technique. The SOI substrate manufacturing method in which bonding is done by using the double etch-stop method requires an advanced technique called a thin-film epitaxial technique. Additionally, since selective etching needs to be performed twice with the opposite properties, the uniformity of the thin silicon film formed is degraded. In the SOI substrate manufacturing method using the combination of the single etch-stop method and the oxidation method, selective etching needs to be performed only once. Consequently, the uniformity of the film thickness is improved, and the film thickness controllability is also improved since the final silicon film thickness can be controlled by the oxidation reaction after the selective etching. This makes the method applicable to devices using a silicon film whose thickness of 0.1 µm or smaller. However, the method cannot be applied to devices which require a silicon layer having a film thickness is 0.1 µm or larger. This narrows the application range of an SOI substrate.

### Summary of the Invention

It is, therefore, a principal object of the present invention to provide an improved method of manufacturing a thin-film SOI substrate.

It is another object of the present invention to provide a method of manufacturing an SOI substrate having an SOI layer which is improved in the uniformity of a film thickness and made from high-quality lightly doped single-crystal silicon.

To achieve the above objects of the present invention, according to one aspect of the present invention, there is provided a method of manufacturing an SOI substrate, comprising the step of forming a semiconductor layer on one surface of a first semiconductor substrate containing an impurity of a certain conductivity type at a first impurity concentration, the semiconductor layer containing the impurity of a certain conductivity type at a second impurity concentration higher than the first impurity concentration, the step of bonding a surface of the semiconductor layer of the first semiconductor substrate to a second semiconductor substrate covered with an insulating film, the step of exposing the semiconductor layer by removing the first semiconductor substrate from a surface on which the semiconductor layer is not formed, and the annealing step of decreasing the impurity concentration of the semiconductor layer by heating the second semiconductor substrate, bonded to the semiconductor layer, in an oxidizing atmosphere.

### Brief Description of the Drawings

Figs. 1A to 1D are sectional views showing the manufacturing steps of an SOI substrate according to an embodiment of the present invention;
Fig. 2 is a graph showing the relationship between the boron concentration and the depth in a silicon film after selective etching in the embodiment of the present invention;
Fig. 3 is a graph showing the relationship between the boron concentration and the depth when annealing is performed in an oxidizing atmosphere after the selective etching in the embodiment of the present invention;
Fig. 4 is a graph showing the relationship between the boron concentration and the depth when the annealing is performed in an oxidizing atmosphere after selective etching in the embodiment of the present invention;
Fig. 5 is a graph showing the relationship between the boron concentration and the depth when annealing is performed in a nitrogen atmosphere after the selective etching in the embodiment of the present invention;
Figs. 6A to 6C are sectional views showing the manufacturing steps of an SOI substrate using a conventional bonding method;
Figs. 7A to 7E are sectional views showing the manufacturing steps of an SOI substrate using a conventional double etch-stop method; and
Figs. 8A to 8E are sectional views showing the manufacturing steps of an SOI substrate using a conventional single etch-stop method and an oxidation method.

### Detailed Description of the Preferred Embodiments

Embodiments of the present invention will be described in detail below. Note that in the following description of the embodiments, the same reference numerals as in the conventional examples previously explained denote the same parts.

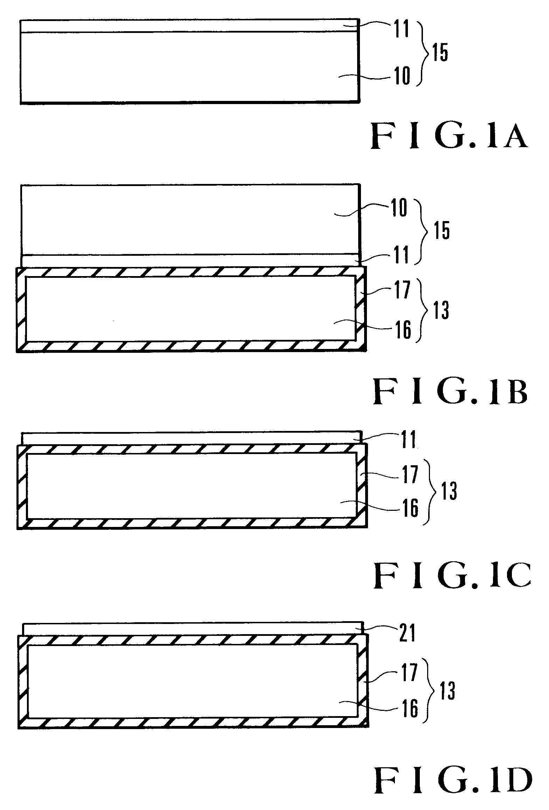

In an embodiment shown in Figs. 1A to 1D, a p-type heavily doped silicon layer 11 of about 5 x 10¹⁹ /cm³ is formed by ion implantation or diffusion on a lightly doped silicon wafer 10 of about 10¹⁶ to 10¹⁸ /cm³ for forming an active layer, thereby obtaining an active layer side wafer 15. The conductivity type of the substrate can be either an n or p type. If boron is used as the p-type impurity, the boron concentration of the heavily doped silicon layer 11 is desirably 5 x 10¹⁹ /cm³ or higher. When, for example, an EPW solution is used in selective etching, the silicon etching rate starts decreasing when the boron concentration in silicon is 2 x 10¹⁹ /cm³, decreases to about 1/25 when the boron concentration in silicon is 5 x 10¹⁹, and decreases to 1/100 when the boron concentration is 7 x 10¹⁹ /cm³, according to the reference (N.F. Raley, Y. Sugiyama, and T. Van Duzer, J. Electrochem. Soc. Vol. 131, No. 1, p. 161). This fact indicates that the lower the etching rate of the p-type heavily doped silicon layer, the larger the etch-stop effect and the higher the uniformity of the film thickness of the heavily doped silicon layer exposed after the etching. This heavily doped boron layer finally serves as a device formation layer, so if this film thickness is nonuniform, the performance of LSIs formed varies, and this leads to a decrease in the LSI fabrication process yield. For this reason, when an EPW solution is to be used, it is desirable that the boron concentration of the p-type heavily doped silicon layer be 5 x 10¹⁹ /cm³ or higher. It is naturally possible to decrease the boron concentration if a novel etching solution with which the etching selectivity is increased even at low boron concentrations is found in the future.

Subsequently, as in Fig. 1B, the active layer side wafer 15 is bonded to a handle wafer 13 which is formed by forming a silicon oxide film 17 by thermally oxidizing the surfaces of a silicon wafer 16. The thickness of this silicon oxide film 17 is 0.1 to 1 µm. After the bonding, annealing is performed to increase the bond strength. This annealing is done at a temperature of 900 to 1000°C in order to suppress rediffusion of the impurity in the p-type heavily doped layer.

The lightly doped silicon wafer 10 of the active layer side wafer 15 is then selectively etched from the surface away from the bonded surface by using a concentration-difference etching solution such as a KOH solution or an EPW solution. This selective etching is done up to the heavily doped silicon layer 11. The etching stops when reaching this heavily doped silicon layer 11, since the silicon layer 11 has an impurity concentration higher than that of the lightly doped silicon layer 10 (Fig. 1C). At that time, the etching rate of the p-type lightly doped silicon layer 10 is 0.6 to 0.7 µm/min. To reduce the selective etching time, it is possible to perform the selective etching after the thickness of the silicon wafer 10 is decreased by mechanically removing most of the silicon wafer 10 of the active layer side wafer 15. Grinding or polishing is usable as this method of mechanical removal.

When annealing is then performed in a reducing atmosphere, the impurity in the p-type heavily doped silicon layer 11 diffuses into the atmosphere from the surface of the silicon layer 11 during the annealing. Consequently, the impurity in the silicon layer 11 decreases to turn the heavily doped silicon layer 11 into a lightly doped silicon layer 21 (Fig. 1D).

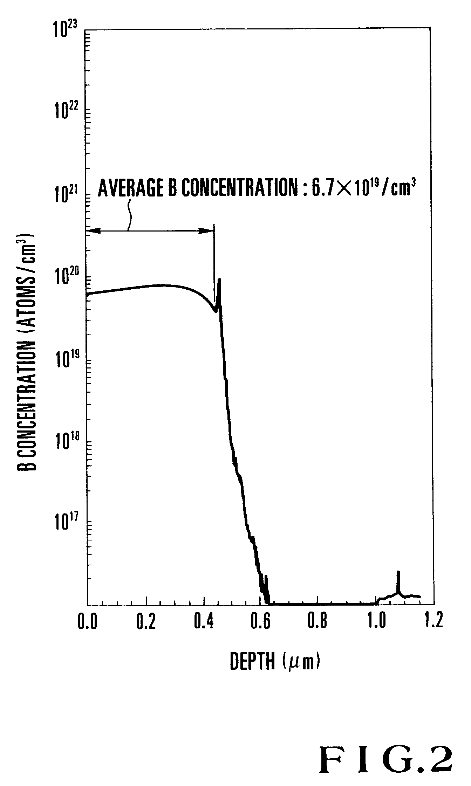

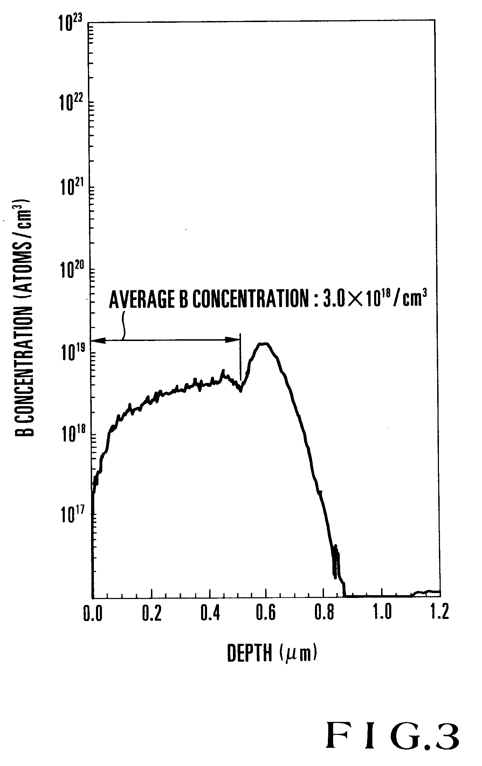

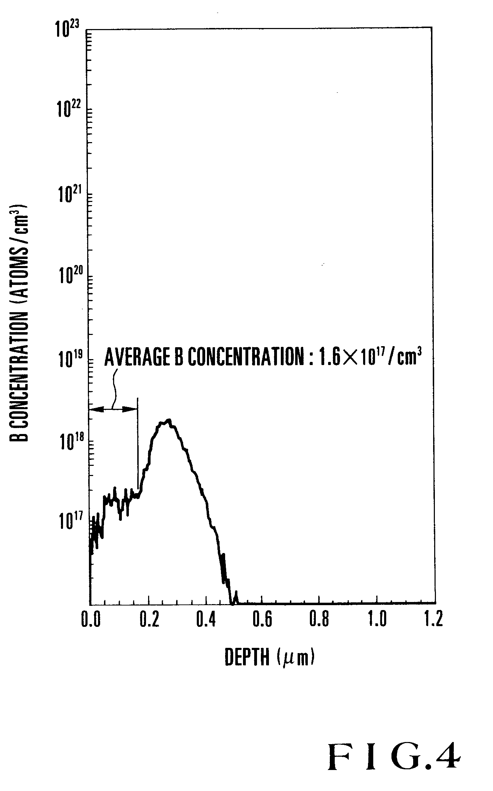

Fig. 3 and Fig. 4 show the effect of annealing in the reducing atmosphere. More specifically, Fig. 2 shows the result of SIMS (Secondary Ion Mass Spectroscopy) analysis of the boron concentration in the heavily doped silicon layer 11 having a film thickness of about 0.5 µm after the selective etching was performed, i.e., shows the relationship between the boron concentration [atoms/cm³] and the depth [µm]. Fig. 3 shows the relationship between the boron concentration [atoms/cm³] and the depth [µm] when annealing was done in a hydrogen atmosphere at 1100°C for one hour. As can be seen from Fig. 3, as a result of the annealing in the hydrogen atmosphere the boron concentration in the silicon film decreased to 3.0 x 10¹⁸ /cm³, about 1/20 the boron concentration before the annealing. Fig. 4 shows the result of annealing performed for the heavily doped silicon layer 11 with a film thickness of 0.2 µm in a hydrogen atmosphere at 1100°C for one hour. As is apparent from Fig. 4, a decrease in boron concentration is more conspicuous; the boron concentration in the silicon film 11 decreased to 1.6 x 10¹⁷ /cm³, i.e., about 1/400 the boron concentration before the annealing. Although the annealing time is one hour in this embodiment, it is readily possible to estimate that the boron concentration further decreases if the annealing time is prolonged. The annealing described above does not degrade the crystallinity of the silicon film or the uniformity of the film thickness.

Also, the reducing atmosphere used herein need not be a 100% reducing gas. That is, it is possible to use a gas mixture in which a reducing gas is contained in an inert gas to the extent to which neither an oxide film nor a nitride film is formed on the surface of a silicon film.

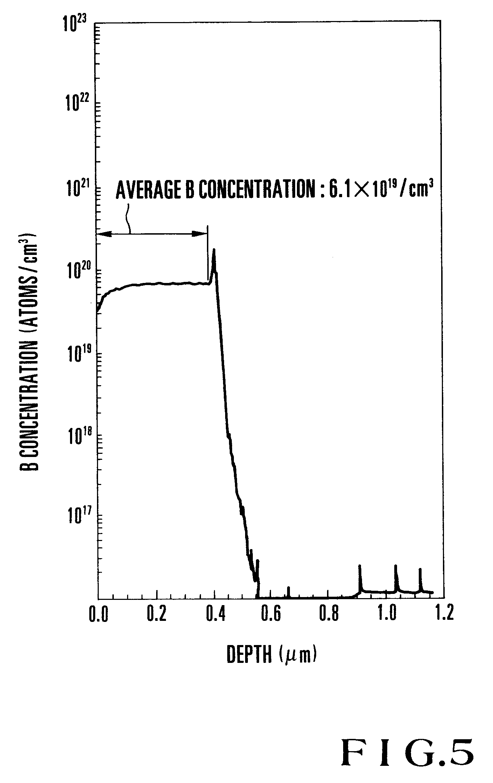

Fig. 5 shows the relationship between the boron concentration [atoms/cm³] and the depth [µm] when annealing was performed using only an inert gas. This annealing was done in a nitrogen (N₂) atmosphere at 1100°C for one hour. The characteristics shown in Fig. 5 show that a decrease in boron concentration caused by the annealing is at most about 10%. Even in a 100% nitrogen atmosphere, an oxide film is formed on the surface of silicon in the very early stages of annealing due to air taken into an annealing apparatus when a material to be annealed is placed in the apparatus, and this oxide film prevents diffusion of boron (B) from the silicon film into the atmosphere. Therefore, since the reducing gas is contained in the inert gas, the silicon oxide film formed on the silicon film is removed by the reducing reaction to expose the silicon surface, and diffusion of boron into the atmosphere proceeds from this silicon film surface. This demonstrates that the reducing gas in the atmosphere during annealing is essential.

Performing annealing in a reducing atmosphere as described above is a manufacturing method which is also effective in the productivity. Since the manufacture is readily possible using a simple apparatus, the method is superior in the mass-productivity.

The same effect as in the reducing atmosphere can be obtained by annealing in a vacuum. That is, a substrate manufactured by the steps up to Fig. 1C is placed in a vacuum apparatus having a heating mechanism, and the substrate is heated after the vacuum degree is sufficiently raised. The result is that boron diffuses from the heavily doped silicon layer 11 into the vacuum. This decreases the boron concentration in the heavily doped silicon layer 11 to transform the heavily doped silicon layer 11 into the lightly doped silicon layer 17 (Fig. 1D). Also, the higher the ultimate evacuation power of the vacuum apparatus, the better the obtained result. If sample heating is performed in a low vacuum, the substrate surface is oxidized by residual oxygen or water in the apparatus even in a vacuum. This prevents diffusion of boron into the vacuum, and the result is that the boron concentration in the heavily doped silicon layer 11 does not decrease. This method of performing annealing in a vacuum is inferior in the productivity to the above-mentioned embodiment in which annealing is done in a reducing atmosphere. However, if defects are produced in an SOI layer, the method can suppress the influence of the defects. For example, if an SOI layer has crystal defects and these defects have reached a buried oxide layer, in the above embodiment in which annealing is performed in a reducing atmosphere, the reducing atmosphere reaches the buried oxide through the crystal defects to make the oxide disappear, destroying the SOI structure. However, if annealing is done in a vacuum, this destruction of the SOI structure is suppressed. Also, in the above embodiment in which annealing is performed in a reducing atmosphere, crystal defects look like holes if the reducing reaction is remarkable, and this reduces the product value. In contrast, when annealing is done in a vacuum, crystal defects, if any, have no influence on a thin-film SOI structure. This minimizes the influence of crystal defects.

In the embodiment shown in Figs. 1A to 1D, after the semiconductor layer 11 of the semiconductor substrate 10 and the semiconductor substrate 16 covered with the insulating film 17 are bonded as in Fig. 1B, the semiconductor layer 11 is exposed by etching the semiconductor substrate 10 from the surface on which the semiconductor layer 11 is not formed. Thereafter, a native oxide (not shown) adhered to the surface of the semiconductor substrate 16 is removed by, e.g., heating in a reducing atmosphere. The reducing gas is then switched to an inert gas, and the semiconductor substrate is heated in the inert gas atmosphere. This decreases the impurity concentration in the semiconductor layer 11, forming the lightly doped semiconductor layer 21, as in Fig. 1D.

By this method, it is possible to prevent sublimation (disappearance) of the buried oxide and to reduce the cost. In this embodiment, it is also possible to oxidize the SOI layer in an oxidizing atmosphere after the annealing step performed in a reducing gas atmosphere or an inert gas atmosphere, remove the oxide film, and decrease the impurity concentration of the semiconductor layer 21. In this case, it is possible not only to simply decrease the impurity concentration to a predetermined value by using the action of only the outward diffusion by the annealing but also to further decrease the impurity concentration of the SOI layer by using the effect of drawing boron by the later oxidation treatment as well. When the sample shown in Fig. 4 is oxidized at 1000°C for one hour and the resultant oxide film is removed, an SOI layer 0.1 µm thick is obtained. The impurity concentration in this SOI layer is 4 x 10¹⁶ /cm³, i.e., decreases to 1/4 the concentration before the oxidation. Additionally, since the surface of an SOI layer formed by the etch-stop method is rough, the uniformity of the SOI layer can be improved about 10 times or more by oxidizing the surface and removing the produced oxide film.

As has been described in detail above, in the method of manufacturing an SOI substrate having an SOI layer formed by forming a silicon layer on an insulating film according to the present invention, a heavily doped silicon film formed by selective etching utilizing the difference between the impurity concentrations is annealed in a reducing atmosphere or in a vacuum, thereby decreasing the impurity concentration. This makes it possible to manufacture a substrate with an SOI structure having a thin lightly doped silicon film which has a high crystallinity and a high film thickness uniformity and in which device fabrication is possible.

## Claims

1. A method of manufacturing an SOI substrate, characterized by comprising:
the step of forming a semiconductor layer (11) on one surface of a first semiconductor substrate (10) containing an impurity of a certain conductivity type at a first impurity concentration, said semiconductor layer (11) containing said impurity of a certain conductivity type at a second impurity concentration higher than the first impurity concentration;
the step of bonding a surface of said semiconductor layer (11) of said first semiconductor substrate (10) to a second semiconductor substrate (16) covered with an insulating film (17);
the step of exposing said semiconductor layer (11) by removing said first semiconductor substrate (10) from a surface on which said semiconductor layer (11) is not formed; and
the annealing step of decreasing the impurity concentration of said semiconductor layer (11) by heating said second semiconductor substrate (16), bonded to said semiconductor layer (11), in a reducing atmosphere.

2. A method according to claim 1, wherein the impurity of a certain conductivity type is a p-type impurity.

3. A method according to claim 2, wherein the p-type impurity is boron.

4. A method according to claim 1, further comprising the steps of:
forming an oxide film by oxidizing said SOI substrate in a oxidizing atmosphere after the annealing step;
removing said oxide film; and
decreasing the impurity concentration of said semiconductor layer (11).

5. A method according to claim 1, wherein the step of exposing said semiconductor layer (11) is to polish and etch said first semiconductor substrate (10).

6. A method according to claim 1, wherein the annealing step is to heat said semiconductor substrate in a vacuum.

7. A method of manufacturing an SOI substrate, characterized by comprising:
the step of forming a semiconductor layer (11) on one surface of a first semiconductor substrate (10) containing an impurity of a certain conductivity type at a first impurity concentration, said semiconductor layer (11) containing said impurity of a certain conductivity type at a second impurity concentration higher than the first impurity concentration;
the step of bonding a surface of said semiconductor layer (11) of said first semiconductor substrate (10) to a second semiconductor substrate (16) covered with an insulating film (17);
the step of exposing said semiconductor layer (11) by removing said first semiconductor substrate (10) from a surface on which said semiconductor layer (11) is not formed;
the step of removing a native oxide on the surface of said semiconductor substrate; and
the annealing step of decreasing the impurity concentration of said semiconductor layer (11) by heating said semiconductor substrate in an inert gas atmosphere.

8. A method according to claim 7, wherein the step of removing said native oxide is done in an inert gas atmosphere containing a reducing gas.

9. A method according to claim 7, further comprising the steps of:
forming an oxide film by oxidizing said SOI substrate in a oxidizing atmosphere after the annealing step;
removing said oxide film; and
decreasing the impurity concentration of said semiconductor layer (11).
